Europäisches Patentamt

(19) European Patent Office

Office européen des brevets

(11) Numéro de publication: **0 123 340**
**B1**

(12) **FASCICULE DE BREVET EUROPEEN**

(45) Date de publication du fascicule du brevet:
06.08.86

(21) Numéro de dépôt: **84200455.8**

(22) Date de dépôt: **29.03.84**

(51) Int. Cl.⁴: **G 01 R 29/26**, G 01 R 31/26

(54) Circuit de mesure des caractéristiques de bruit de fond d'un composant électronique.

(30) Priorité: **18.04.83 FR 8306413**

(43) Date de publication de la demande:
**31.10.84 Bulletin 84/44**

(45) Mention de la délivrance du brevet:
**06.08.86 Bulletin 86/32**

(84) Etats contractants désignés:
**AT DE GB IT NL SE**

(56) Documents cités:
**REVUE DE PHYSIQUE APPLIQUEE, vol. 17, no. 12, décembre 1982, pages 793-799, Orsay, FR; G. BLASQUEZ et al.: "Etude expérimentale du bruit de fond des amplificateurs et transistors par une méthode de mesure directe"**
**REVUE DE PHYSIQUE APPLIQUEE, vol. 15, no. 5, mai 1980, pages 1007-1011, Paris, FR; G.A. BLASQUEZ: "Une méthode de mesure simple et directe du facteur de bruit pour les amplificateurs et les transistors"**
**C.R. HEBD. SEA. ACAD. SCIENCES, séries A-B, vol. 289, no. 13, novembre 1979, pages 219-222, Paris, FR; G.A. BLASQUEZ: "Principe d'une mesure directe du facteur de bruit de fond des quadripoles"**

(73) Titulaire: **CENTRE NATIONAL DE LA RECHERCHE SCIENTIFIQUE (CNRS), 15, Quai Anatole France, F-75700 Paris (FR)**

(72) Inventeur: **Blasquez, Gaby, 15 rue St Exupéry, F-31120 Portet sur Garonne (FR)**
Inventeur: **Tosi, Rolan, 6 Avenue Olin, F-93600 Aulnay sous Bois (FR)**
Inventeur: **Borreil, Joel, 26 rue des Géraniums, F-31400 Toulouse (FR)**

(74) Mandataire: **Barre, Philippe, Cabinet Barre-Gatti-Laforgue 95 rue des Amidonniers, F-31069 Toulouse Cédex (FR)**

## Description

L'invention concerne un circuit de mesure des caractéristiques de bruit de fond d'un composant électronique. Elle s'applique en particulier pour mesurer les caractéristiques de bruit de fond ramenées à l'entrée de transistors bipolaires, notamment en basses et moyennes fréquences.

On sait que l'une des caractéristiques fondamentales des composants électroniques, notamment des composants actifs (transistors, amplificateurs élémentaires, ...) est constituée par le bruit de fond généré par ledit composant et ramené à l'entrée de celui-ci, bruit de fond dont la connaissance permet de définir l'amplitude du plus petit signal qui peut être traité par le composant.

Les circuits de mesure de bruit de fond classiques effectuent une mesure indirecte de ce bruit de fond, en mesurant le bruit à la sortie dudit composant, en mesurant le gain de celui-ci et en faisant le rapport de ces grandeurs pour déduire le bruit de fond ramené à l'entrée du composant. Ce principe traditionnel de mesure qui est utilisé de façon universelle depuis le début de l'électronique s'est imposé de façon naturelle en raison des très faibles valeurs du bruit à l'entrée: le bruit est mesuré à la sortie du composant pour profiter du gain propre de celui-ci, ce qui permet d'avoir à mesurer en sortie un signal de bruit plus important, compatible avec les appareils de mesure existants.

Toutefois, ce principe de mesure présente le grave inconvénient de nécessiter trois mesures distinctes, l'une du bruit à la sortie, une autre d'un signal auxiliaire injecté à l'entrée dans le but de déterminer le gain, enfin une troisième, de ce signal à la sortie. En outre, des moyens de calcul sont nécessaires pour déterminer le gain et le bruit à l'entrée à partir des résultats de ces mesures; de plus, un générateur de signal auxiliaire doit être prévu pour la détermination du gain.

Il s'ensuit que la mise en œuvre du principe traditionnel de mesure ci-dessus évoquée conduit à des appareillages de structure complexe, imprécis en raison des erreurs cumulées dues aux trois mesures et exigeant des temps de mesure qui peuvent être très longs.

La présente invention se propose de fournir un nouveau circuit de mesure remédiant aux défauts sus-évoqués des circuits connus.

Un objectif de l'invention est en particulier de fournir un dispositif apte à réaliser une mesure directe du bruit de fond ramené à l'entrée du composant, sans avoir à effectuer une mesure de gain ou à utiliser des moyens de calcul ou un générateur de signal auxiliaire.

Un autre objectif de l'invention est d'effectuer la mesure directe sus-évoquée au moyen d'un circuit de structure simple et peu coûteuse.

Un autre objectif lié aux précédents est d'augmenter considérablement à la fois la rapidité de la mesure et sa précision.

A cet effet, le circuit de mesure visé par l'invention est du type comprenant une alimentation électrique de polarisation continue par rapport à une référence de potentiel continue, une impédance de charge reliée à ladite alimentation et à une première borne destinée à être connectée à la sortie du composant, un amplificateur ayant une entrée reliée à la première borne précitée et une sortie reliée à des moyens de mesure des caractéristiques du signal issu dudit amplificateur, et une impédance de source, reliée à une seconde borne destinée à être connectée à l'entrée du composant; selon la présente invention, la sortie de l'amplificateur est rebouclée sur l'impédance de source par l'entremise d'un pont diviseur ayant une borne haute connectée à ladite sortie d'amplificateur, une borne médiane connectée à l'impédance de source et une borne basse reliée à la référence de potentiel continu.

Un tel circuit fonctionne sur le principe d'un asservissement à contre-réaction ayant une commande constituée par le bruit de fond à l'entrée du composant et une sortie où se trouve disponible le bruit de fond à mesurer multiplié par un facteur d'amplification constant et connu par construction. Un tel circuit profite de l'avantage des circuits classiques qui est de mesurer un signal de bruit amplifié (donc d'amplitude mesurable), mais élimine les défauts de ces circuits du fait que le signal mesuré est directement proportionnel au bruit de fond ramené à l'entrée; il évite donc d'avoir à procéder à une mesure du gain du composant et supprime les calculs nécessaires dans les circuits classiques et la nécessité d'un générateur de signal auxiliaire. De plus, le caractère direct de la mesure combinée à l'amplification de la grandeur à mesurer conduit à une précision notablement améliorée par rapport aux dispositifs connus.

Selon un mode de réalisation permettant de mesurer le bruit de fond dans une gamme étendue de conditions de fonctionnement du composant, on choisit:

— comme alimentation de polarisation continue, une source de tension de valeur réglable, et

— comme impédance de charge et impédance de source, des impédances variables.

Cela permet de procéder à la mesure du bruit de fond en plusieurs points (de façon continue ou discrète) de la plage de fonctionnement du composant.

En outre, selon une autre caractéristique de l'invention, l'impédance de charge et l'impédance de source sont des impédances non linéaires, adaptées pour conférer à l'étage constitué par lesdites impédances et par le composant un gain en tension sensiblement indépendant de la polarisation continue dudit composant.

De telles dispositions assurent en pratique une simplification importante de la structure des impédances de charge et de source, en évitant, d'une part, la multiplicité de composants qu'imposent les charge et source de type linéaire, d'autre part, les commutations qu'exige ce type de charge et source. Dans le cas de l'invention, le choix d'impédances non linéaires, adaptées au type de composant à mesurer, permet de limiter leur nombre et de supprimer la nécessité des commutations.

Par ailleurs, selon une autre caractéristique de l'invention, l'amplificateur utilisé est un amplificateur différentiel ayant une seconde entrée reliée à une seconde alimentation continue. Cette disposition assure un asservissement précis de la tension continue de sortie du composant à la seconde alimentation. Cette dernière est en particulier une source de tension de valeur réglable pour permettre des mesures dans une plage étendue de conditions de fonctionnement du composant.

De plus, dans le but de bénéficier d'une large bande passante (mesure de bruit précise dans une large plage de fréquence), le circuit comprend les caractéristiques suivantes:

— une impédance est interposée entre la seconde entrée de l'amplificateur et la seconde alimentation continue,

— un circuit de contre-réaction est connecté entre ladite seconde entrée de l'amplificateur et la sortie de celui-ci, ce circuit de contre-réaction étant adapté pour conférer à l'étage d'amplification formé par l'amplificateur, l'impédance et le circuit de contre-réaction un gain statique très supérieur à son gain dynamique.

Par gain statique très supérieur au gain dynamique, on entend un gain statique d'au moins un ordre de grandeur (et si possible de plusieurs) supérieur au gain dynamique (par exemple rapport de 100 à 1000).

Le gain statique élevé assure une grande précision de l'asservissement de la polarisation continue du composant, cependant qu'un gain dynamique faible permet un fonctionnement dans une plage de fréquences étendue.

D'autres caractéristiques, buts et avantages de l'invention se dégageront de la description qui suit en référence au dessin annexé qui présente un exemple de circuit conforme à l'invention dans le cas d'une application à la mesure du bruit de fond d'un transistor bipolaire; sur ce dessin:

— la figure 1 est un schéma électronique de ce circuit,

— les figures 2 et 3 sont des schémas symboliques destinés à faciliter la compréhension de ce circuit et de son fonctionnement.

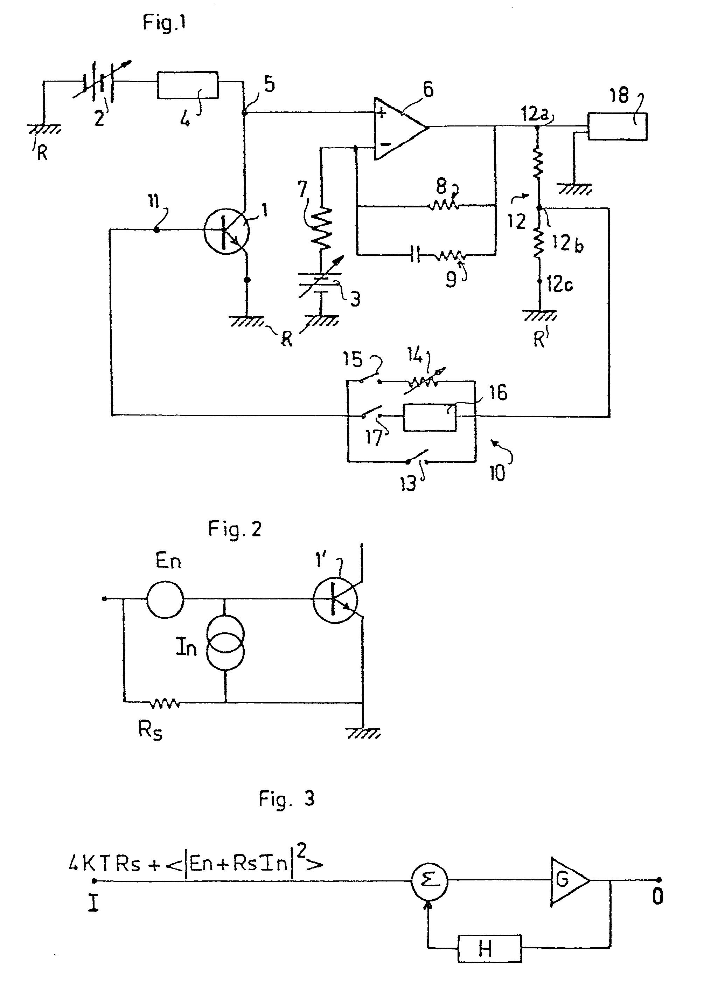

Le circuit représenté en exemple à la figure 1 est destiné à mesurer les caractéristiques de bruit de fond d'un transistor 1, ramené à l'entrée de celui-ci, c'est-à-dire:

— d'une part, la densité spectrale de puissance du générateur équivalent de bruit en tension ramené à l'entrée,

— d'autre part, la densité spectrale de puissance du générateur équivalent de bruit en courant ramené à l'entrée,

— enfin, le facteur de bruit à résistance donné.

On a schématisé à la figure 1 un transistor NPN mais le circuit est utilisable pour caractériser des transistors PNP à condition de changer la polarité des sources.

Ce circuit comprend deux alimentations électriques 2 et 3 adaptées pour autoriser un réglage de la tension. Ces alimentations sont du type à faible bruit, par exemple pile cadmium/nickel associée à un potentiomètre dix tours.

L'alimentation 2, dite première alimentation, est reliée à une impédance de charge variable 4 constituée par une pluralité de diodes du type «Schottky» (silicium, faible bruit). Une dizaine de diodes montées en série peuvent en particulier être prévues; le cas échéant, des capacités de faible valeur sont branchées en parallèle en vue d'augmenter la stabilité du circuit.

Cette impédance 4 est reliée à une borne 5, dite première borne, à laquelle est connecté le collecteur du transistor 1.

A cette même borne est reliée l'entrée positive d'un amplificateur différentiel 6, de faible bruit (4 nanovolts par $\sqrt{Hz}$, du type opérationnel à impédance d'entrée élevée ($10^{10}$ ohms en parallèle avec 3,5 picofarads) et à impédance de sortie faible (200 ohms). Cet amplificateur est choisi pour posséder un produit gain-bande élevé (70 mégahertz).

En particulier, on peut choisir un amplificateur du type «50 K ANALOG-DEVICES».

L'entrée négative de l'amplificateur 6 est reliée par l'entremise d'une impédance constituée en l'exemple par une résistance 7, à l'alimentation 3, dite seconde alimentation. La résistance 7 présente une valeur faible pour que sa contribution en bruit soit négligeable.

Entre la sortie de l'amplificateur 6 et son entrée négative est relié un circuit de contre-réaction constitué par une branche 8 purement résistive montée en parallèle avec une branche 9 à la fois résistive et capacitive.

Les valeurs de la résistance 7 et des résistances et capacité des branches 8 et 9 sont adaptées pour conférer à l'étage d'amplification visé un gain statique très élevé et un gain dynamique faible. Par exemple, les valeurs suivantes peuvent être adoptées:

— résistance 7: de l'ordre de 100 ohms,

— résistance 8: de l'ordre de 10 kiloohms,

— résistance de la branche 9: environ 1 kiloohm,

— capacité de la branche 9: 1 à 10 microfarads.

Le gain statique d'un tel montage est égal ou supérieur à 100 et le gain dynamique est de l'ordre de 10.

De plus, la sortie de l'amplificateur 6 est rebouclée sur une impédance de source 10 reliée à une borne 11, dite seconde borne, où est connectée la base du transistor. Ce rebouclage s'effectue par l'entremise d'un pont diviseur 12, en l'exemple purement résistif.

L'impédance 10 est reliée à la borne médiane 12b du pont; la résistance haute de celui-ci peut être de l'ordre de 180 ohms et sa résistance basse de 20 ohms, de façon à donner un rapport de pont r égal à 1/10.

L'impédance de source 10 est en l'exemple constituée par trois branches commutables, en parallèle:

— un court-circuit doté d'un interrupteur 13,

— une résistance variable 14 en série avec un interrupteur 15, et

— une impédance non linéaire 16 de même type que l'impédance de charge 4, en série avec un interrupteur 17.

Par ailleurs, la sortie de l'amplificateur 6 attaque des moyens de mesure 18, adaptés pour mesurer la densité spectrale de puissance du signal de sortie issu de l'amplificateur. Ces moyens de mesure peuvent être constitués par un analyseur de spectre de type analogique ou numérique ou par un voltmètre sélectif, précédé par une chaîne d'amplification de faible bruit.

Il est à noter que, de façon traditionnelle, les alimentations 2 et 3, l'émetteur du transistor 1 et la borne basse du pont 12 sont reliés à une référence (R) de potentiel de même que conventionnellement les moyens de mesure.

Afin de faciliter la compréhension du fonctionnement du circuit décrit, la figure 2 représente le schéma équivalent en bruit de fond du transistor 1, supposé attaqué par l'impédance 10 (de valeur Rs). Dans ce schéma, le transistor avec son bruit propre est supposé équivalent à un transistor 1' sans bruit, associé à un générateur de bruit en tension En et à un générateur de bruit en courant In.

Le bruit de fond du transistor est caractérisé par la densité spectrale de puissance du bruit en tension $\langle | En |^2 \rangle$ et la densité spectrale de puissance du bruit en courant $\langle | In |^2 \rangle$. D'un point de vue pratique, on caractérise plus souvent le bruit de l'étage constitué par le transistor et la résistance de source Rs par le facteur de bruit F, donné par la formule suivante:

$$F = \frac{4 \, KTRs + \langle | En + RsIn |^2 \rangle}{4 \, K \, TRs}$$

K étant la constante de Boltzmann et T une température absolue de référence égale à 290° Kelvin.

On peut démontrer que le circuit conforme à l'invention est équivalent à un système asservi tel que symbolisé à la figure 3, comprenant:
— un signal de commande I constitué par la valeur quadratique moyenne du bruit total en tension et un courant du transistor 1' et de la résistance Rs,
— un amplificateur G constitué par l'étage formé par le transistor à mesurer 1, son impédance de charge 4, son impédance de source 10 et l'étage d'amplification 6, 7, 9,
— un bloc H représentant le pont diviseur 12,
— un sommateur ε symbolisant le rebouclage en contre-réaction.

Le produit G · H étant par construction grand devant l'unité, la valeur quadratique moyenne du bruit en tension à la sortie est égale à la commande divisée par H. Par conséquent, la valeur quadratique moyenne du signal délivré vers les moyens de mesure 18 est égale au bruit de fond ramené à l'entrée du transistor et de l'impédance de source, multiplié par un facteur d'amplification égal au carré de l'inverse du rapport du pont diviseur $(\frac{1}{2})^2 = 100$.

La mesure du bruit en tension ramené à l'entrée du transistor $\langle | En |^2 \rangle$ est obtenue pour Rs = 0 lorsque l'impédance de source est mise en court-circuit (branche 13).

La mesure du bruit en courant ramené à l'entrée $\langle | In |^2 \rangle$ est obtenue pour Rs très élevée, telle que

$$Rs > \sqrt{\frac{\langle | En |^2 \rangle}{\langle | In |^2 \rangle}}$$

Dans ce cas, on utilise de préférence l'impédance 16 (à diodes), laquelle, en liaison avec l'impédance de charge 4 (également à diodes), confère à l'étage constitué par lesdites impédances et le composant un gain en tension sensiblement constant, indépendant de la polarisation et des caractéristiques du transistor lui-même, et ce sans aucune commutation à réaliser. En effet, ces impédances à diodes ont des valeurs variables inversement proportionnelles aux courants qui les traversent.

Enfin, le facteur de bruit F à résistance donné Rs est obtenu en prenant pour impédance 10 une résistance égale à Rs; la mesure donne le numérateur de F, le dénominateur étant connu.

Il est à noter que, dans le circuit de l'invention, la tension collecteur du transistor 1 est automatiquement réglée suivant le principe des asservissements grâce à une commande fournie par l'alimentation 3. Le courant collecteur est alors facilement réglé par l'alimentation 2 et l'impédance 4. Ce système rend la tension collecteur totalement indépendante du courant collecteur.

## Revendications

1. Circuit de mesure des caractéristiques de bruit de fond, ramenées à l'entrée, d'un composant électronique, comprenant une alimentation électrique (2) de polarisation continue par rapport à une référence de potentiel continue (R), une impédance de charge (4) reliée à ladite alimentation et à une première borne (5) destinée à être connectée à la sortie du composant, un amplificateur (6) ayant une entrée reliée à la première borne (5) précitée et une sortie reliée à des moyens (18) de mesure des caractéristiques du signal issu dudit amplificateur, et une impédance de source (10) reliée à une seconde borne (11) destinée à être connectée à l'entrée du composant, ledit circuit de mesure étant caractérisé en ce que la sortie de l'amplificateur (6) est rebouclée sur l'impédance de source (10) par l'entremise d'un pont diviseur (12) ayant une borne haute (12a) connectée à ladite sortie d'amplificateur, une borne médiane (12b) connectée à l'impédance de source (10) et une borne basse (12c) reliée à la référence de potentiel continu (R).

2. Circuit de mesure selon la revendication 1, caractérisé en ce que:
— son alimentation de polarisation continue (2) est une source de tension de valeur réglable,
— son impédance de charge (4) et son impédance de source (10) sont des impédances variables.

3. Circuit de mesure selon la revendication 2, caractérisé en ce que l'impédance de charge (4) et l'impédance de source (10) comprennent des impédances non linéaires, adaptées pour conférer à l'étage constitué par lesdites impédances et par le composant un gain en tension sensiblement indépendant de la polarisation continue dudit composant.

4. Circuit de mesure selon la revendication 3, caractérisé en ce que l'impédance de source (10) comprend une impédance non linéaire (16) commutable avec une résistance variable (14) et/ou un court-circuit (13).

5. Circuit de mesure selon l'une des revendications 1, 2, 3 ou 4, caractérisé en ce que l'amplificateur (6) est un amplificateur différentiel ayant une seconde entrée reliée à une seconde alimentation continue (3).

6. Circuit de mesure selon la revendication 5, caractérisé en ce que la seconde alimentation continue (3) est une source de tension de valeur réglable.

7. Circuit de mesure selon l'une des revendications 5 ou 6, caractérisé en ce qu'une impédance (7) est interposée entre la seconde entrée de l'amplificateur (6) et la seconde alimentation continue (3) et en ce qu'un circuit de contre-réaction (8, 9) est connecté entre ladite seconde entrée de l'amplificateur et la sortie de celui-ci, ce circuit de contre-réaction étant adapté pour conférer à l'étage d'amplification formé par l'amplificateur (6), l'impédance (7) et ledit circuit de contre-réaction (8, 9) un gain statique très supérieur à son gain dynamique.

8. Circuit de mesure selon la revendication 7, caractérisé en ce que le circuit de contre-réaction est constitué par une branche résistive (8) montée en parallèle avec une branche (9) à la fois résistive et capacitive.

9. Circuit de mesure selon l'une des revendications 5, 6, 7 ou 8, dans lequel l'amplificateur (6) est du type opérationnel à impédance d'entrée élevée et impédance de sortie faible.

10. Circuit de mesure selon l'une des revendications 5, 6, 7, 8 ou 9, dans lequel l'amplificateur (6) est du type à produit gain-bande passante élevé.

11. Circuit de mesure selon l'une des revendications 1, 2, 3, 4, 5, 6 ou 7, 8, 9 ou 10, dans lequel les moyens de mesure (18) sont adaptés pour mesurer la densité spectrale de puissance ou la puissance du signal de sortie issu de l'amplificateur (6).

12. Circuit selon l'une des revendications 1 à 11 pour la mesure des caractéristiques de bruit de fond d'un transistor bipolaire (1) ayant un collecteur appelé à être connecté à la première borne (5) du circuit et une base et un émetteur appelés à être connectés à la seconde borne (11) et au potentiel de référence (R) dudit circuit.

13. Circuit de mesure selon la revendication 12 dans lequel les impédances de charge (4) et de source (10) comprennent des diodes, en particulier du type «Schottky».

## Patentansprüche

1. Schaltung zur Messung der Rauschcharakteristiken von zur Zuleitung gebrachten elektronischen Komponenten, umfassend eine elektrische Stromzuführung (2) mit kontinuierlicher Polarisierung in bezug auf ein kontinuierliches Bezugspotential (R), eine Ladungs-Impedanz (4), welche an besagte Stromzuführung und an eine erste Klemme (5), die zur Verbindung mit der Ausleitung der Komponente bestimmt ist, angeschlossen ist, einen Verstärker (6), welcher eine an vorgenannte erste Klemme (5) angeschlossene Zuleitung und eine an Mittel (18) zur Messung der Charakteristiken des aus besagtem Verstärker hervorgehenden Signals angeschlossene Ausleitung aufweist, und eine Quellen-Impedanz (10), welche an eine zweite Klemme (11) angeschlossen ist, die zur Verbindung mit der Zuleitung der Komponente bestimmt ist, wobei besagte Mess-Schaltung dadurch gekennzeichnet ist, dass die Ausleitung des Verstärkers (6) auf der Quellen-Impedanz (10) durch Einschalten einer Teilungsbrücke (12) befestigt ist, welche eine mit besagter Verstärker-Ausleitung verbundene obere Klemme (12a), eine mit der Quellen-Impedanz (10) verbundene Mittel-Klemme (12b) und eine an das kontinuierliche Bezugspotential (R) angeschlossene untere Klemme (12c) aufweist.

2. Mess-Schaltung nach Anspruch 1, dadurch gekennzeichnet, dass

– ihre Stromzuführung mit kontinuierlicher Polarisierung (2) eine Spannungsquelle mit regulierbarem Wert ist;
– ihre Ladungs-Impedanz (4) und ihre Quellen-Impedanz (10) veränderliche Impedanzen sind.

3. Mess-Schaltung nach Anspruch 2, dadurch gekennzeichnet, dass die Ladungs-Impedanz (4) und die Quellen-Impedanz (10) nicht-lineare Impedanzen umfassen, welche dazu befähigt sind, der aus besagten Impedanzen und aus der Komponente bestehenden Stufe einen Spannungs-Zuwachs zuteil werden zu lassen, welcher von der kontinuierlichen Polarisierung besagter Komponente praktisch unabhängig ist.

4. Mess-Schaltung nach Anspruch 3, dadurch gekennzeichnet, dass die Quellen-Impedanz (10) eine mit einem veränderlichen Widerstand (14) und/oder einem Kurzschluss (13) kommutierbare, nicht-lineare Impedanz (16) umfasst.

5. Mess-Schaltung nach einem der Ansprüche 1, 2, 3 oder 4, dadurch gekennzeichnet, dass der Verstärker (6) ein Differential-Verstärker ist, welcher eine zweite, an eine zweite kontinuierliche Stromzuführung (3) angeschlossene Zuleitung aufweist.

6. Mess-Schaltung nach Anspruch 5, dadurch gekennzeichnet, dass die zweite kontinuierliche Stromzuführung (3) eine Spannungsquelle mit regulierbarem Wert ist.

7. Mess-Schaltung nach einem der Ansprüche 5 oder 6, dadurch gekennzeichnet, dass eine Impedanz (7) zwischen die zweite Zuleitung des Verstärkers (6) und die zweite kontinuierliche Stromzuführung (3) eingeschaltet und dass eine Rückkopplungsschaltung (8, 9) zwischen besagte zweite Zuleitung des Verstärkers und die Ausleitung desselben gelegt ist, wobei diese Rückkopplungsschaltung dazu befähigt ist, der von dem Verstärker (6), der Impedanz (7) und besagter Rückkopplungsschaltung (8, 9) gebildeten Verstärkerstufe einen statischen Gewinn zuteil werden zu lassen, welcher viel höher als sein dynamischer Gewinn ist.

8. Mess-Schaltung nach Anspruch 7, dadurch gekennzeichnet, dass die Rückkopplungsschaltung aus einem Widerstandszweig (8) besteht, welcher parallel zu einem Zweig (9) gelegt ist, der gleichzeitig Widerstands- und kapazitiver Zweig ist.

9. Mess-Schaltung nach einem der Ansprüche 5, 6, 7 oder 8, bei welcher der Verstärker (6) ein Typ ist, welcher mit hoher Zuleitungs-Impedanz und geringer Ausleitungs-Impedanz betrieben wird.

10. Mess-Schaltung nach einem der Ansprüche 5, 6, 7, 8 oder 9, bei welcher der Verstärker (6) ein Typ mit hohem vorübergehendem Bandbreiten-Produkt ist.

11. Mess-Schaltung nach einem der Ansprüche 1, 2, 3, 4, 5, 6 oder 7, 8, 9 oder 10, bei welcher die Messmittel (18) dazu befähigt sind, die Leitungs-Spektraldichte oder die Energie des aus dem Verstärker (6) kommenden Ausgangssignals zu messen.

12. Schaltung nach einem der Ansprüche 1 bis 11 zur Messung der Rauschcharakteristiken eines zweipoligen Transistors (1), welche einen zur Verbindung mit der ersten Klemme (5) der Schaltung gebrauchten Abnehmer und eine Bodenfläche und einen Sender aufweist, welche zur Verbindung mit der zweiten Klemme (11) und mit dem Bezugspotential (R) der besagten Schaltung gebraucht werden.

13. Mess-Schaltung nach Anspruch 12, bei welcher die Ladungs- (4) und Quellen- (10) Impedanzen Dioden, insbesondere des „Schottky"-Typs umfassen.

## Claims

1. Circuit for measuring the background-noise characteristics represented at the input of an electronic component, including an electric power supply (2) with a DC bias with respect to a DC voltage reference (R), a load impedance (4) connected to said power supply and to a first terminal (5) which in turn is connected to the component output, an amplifier (6) with an input connected to the first terminal (5) above and an output connecting to means (18) measuring the characteristics of the signal output from said amplifier, and a source impedance (10) connected to a second terminal (11) in turn connected to the component input, said measuring circuit being characterized in that the output of the amplifier (6) is fed through a voltage divider (12) to the source impedance (10), where said voltage divider has an upper terminal (12a) connected to said amplifier output, a center terminal (12b) connected to the source impedance (10) and a lower terminal (12c) connected to the DC voltage reference (R).

2. Measuring circuit as in claim 1, characterized in that:
— its DC bias supply (2) is an adjustable voltage supply;
— its load impedance (4) and its source impedance (10) are variable impedances.

3. Measuring circuit as in claim 2, characterized in that the load impedance (4) and the source impedance (10) include non-linear impedances suitable to provide the stage consisting of said impedances and the component with a voltage gain essentially independent of the DC bias of said component.

4. Measuring circuit as in claim 3, characterized in that the source impedance (10) includes a non-linear impedance (16) which can be exchanged by switching with a variable resistor (14) and/or a short (13).

5. Measuring circuit as in one of claims 1, 2, 3 or 4, characterized in that the amplifier (6) is a differential amplifier having a second input connected to a second DC power supply (3).

6. Measuring circuit as in claim 5, characterized in that the second DC power supply (3) is an adjustable voltage source.

7. Measuring circuit as in one of claims 5 or 6, characterized in that an impedance (7) is inserted between the second input of the amplifier (6) and the second DC power supply (3) and in that a negative feedback circuit (8, 9) is connected between said second amplifier stage consisting of the amplifier (6), the impedance (7) and said negative feedback circuit (8, 9) with a static gain much higher than its dynamic gain.

8. Measuring circuit as in claim 7, characterized in that the negative feedback circuit consists of a resistive arm (8) in parallel with an arm (9) which is both resistive and capacitive.

9. Measuring circuit as in one of claims 5, 6, 7 or 8, wherein the amplifier (6) is an operational amplifier type with a high input impedance and a low output impedance.

10. Measuring circuit as in one of claims 5, 6, 7, 8 or 9, wherein the amplifier (6) has a high gain-bandwidth product.

11. Measuring circuit as in one of claims 1, 2, 3, 4, 5, 6 or 7, 8, 9 or 10, wherein the measuring means (18) are designed to measure the spectral power density or the power of the output signal of amplifier (6).

12. Circuit as in one of claims 1 through 11 for measuring the background noise characteristics of a bipolar transistor (1) having a collector to be connected to the first terminal (5) of a circuit and a base and an emitter which are to be connected to the second terminal (11) and to the reference potential (R) of said circuit.

13. Measuring circuit as in claim 12, wherein the load impedance (4) and the source impedance (10) include diodes, in particular "Schottky" type diodes.

Fig.1

Fig. 2

Fig. 3

$$4KTR_S + <|E_n + R_s I_n|^2>$$